(19) Europäisches Patentamt

European Patent Office

Office européen des brevets

(11) EP 0 793 342 A2

# (12) EUROPEAN PATENT APPLICATION

(43) Date of publication:
03.09.1997 Bulletin 1997/36

(51) Int. Cl.6: H03K 3/3562

(21) Application number: 97103185.1

(22) Date of filing: 27.02.1997

(84) Designated Contracting States:
DE GB NL

(30) Priority: 28.02.1996 JP 41166/96

(71) Applicant: NEC CORPORATION
Tokyo (JP)

(72) Inventors:
• Ookuri, Jirou,
  NEC IC Microcomputer System, Ltd.,
  Kawasaki-shi, Kanagawa (JP)

• Muramatsu, Tsutomu,
  C/O NEC Microcomp.System, Ltd.
  Kawasaki-shi, Kanagawa (JP)

(74) Representative: Baronetzky, Klaus, Dipl.-Ing. et al
Patentanwälte
Dipl.-Ing. R. Splanemann, Dr. B. Reitzner, Dipl.-Ing. K. Baronetzky
Tal 13
80331 München (DE)

## (54) Flip-Flop Circuit

(57) A master-slave type flip-flop circuit includes a master latch circuit and a slave latch circuit. The master latch circuit includes transfer gates (54, 55) for switching between on and off states in response to a clock signal (CK), transfer gates (56, 57) individually connected in series to the transfer gates (54, 55) for switching between on and off states in response to a data signal (D), and a latch section (50) formed from invertors (58, 59) connected to the latter transfer gates (56, 57). The slave latch circuit includes transfer gates (61, 62) for switching between on and off states in response to the clock signal (CK), transfer gates (63, 64) individually connected in series to the transfer gates (61, 62) for switching between on and off states in response to an output and an inverted output of the latch section (50), and a latch section (60) formed from invertors (65, 66) connected to the latter transfer gates (63, 64).

FIG. 1 (a)

EP 0 793 342 A2

# Description

This invention relates to a flip-flop circuit, and more particularly to a master-slave type flip-flop circuit.

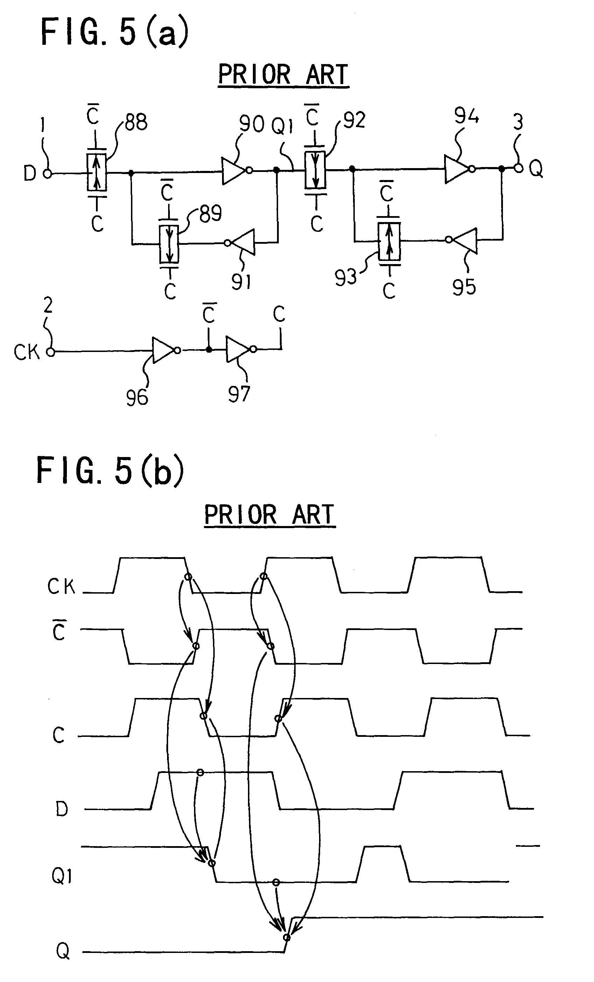

Several exemplary ones of conventional flip-flop circuits will be described with reference to the accompanying drawings. FIG. 5(a) shows in circuit diagram a construction of an exemplary one of conventional flip-flop circuits. Referring to FIG. 5(a), the flip-flop circuit shown has a data input terminal 1 for receiving a data input signal D, a clock input terminal 2 for receiving a clock input signal CK, and an output terminal 3 for outputting a data output signal Q. The flip-flop circuit includes four transfer gates 88, 89 and 92, 93 and six invertors 90, 91 and 94 to 97 connected between the input and output terminals 1 to 3 such that they form a master-slave type flip-flop circuit. In the flip-flop circuit, the transfer gates 88 and 89 and the invertors 90 and 91 form a master latch circuit, and the transfer gates 92 and 93 and the invertors 94 and 95 form a slave latch circuit.

A timing chart when the master-slave type flip-flop circuit described above operates is shown in FIG. 5(b). Referring to FIG. 5(b), when the clock input signal CK has a low ("L") level, the transfer gate 88 exhibits a conducting state, and an inverted signal to the data input signal D is outputted to an output Q1 of the master latch circuit. Then, when the clock input signal CK changes to a high ("H") level, the transfer gates 89 and 92 are rendered conducting, and the master latch circuit holds data and an inverted signal to the output Q1 is outputted to the output Q of the slave latch circuit.

In the master-slave type flip-flop circuit just described, even if the data input signal D exhibits no change, the outputs of the invertors 96 and 97 change each time the clock input signal CK changes. Consequently, power is consumed by the invertors 96 and 97, and the power consumption increases in proportion to the operation frequency. Further, since the clock input signal CK is inputted to the transfer gates 88, 89 and 92, 93 through the invertors 96 and 97, time is required after a change of the clock input signal till a change of the output signal Q, and this increases the transfer delay time as a flip-flop circuit.

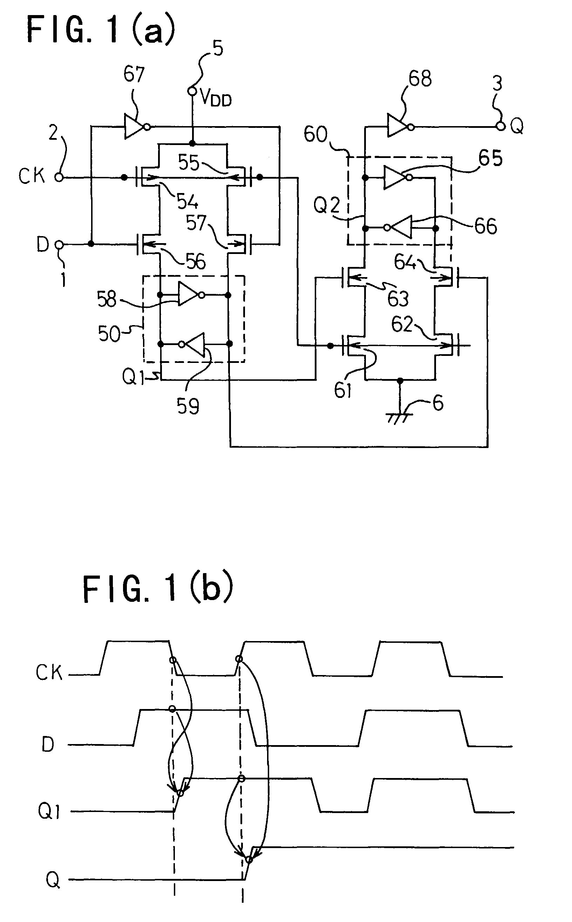

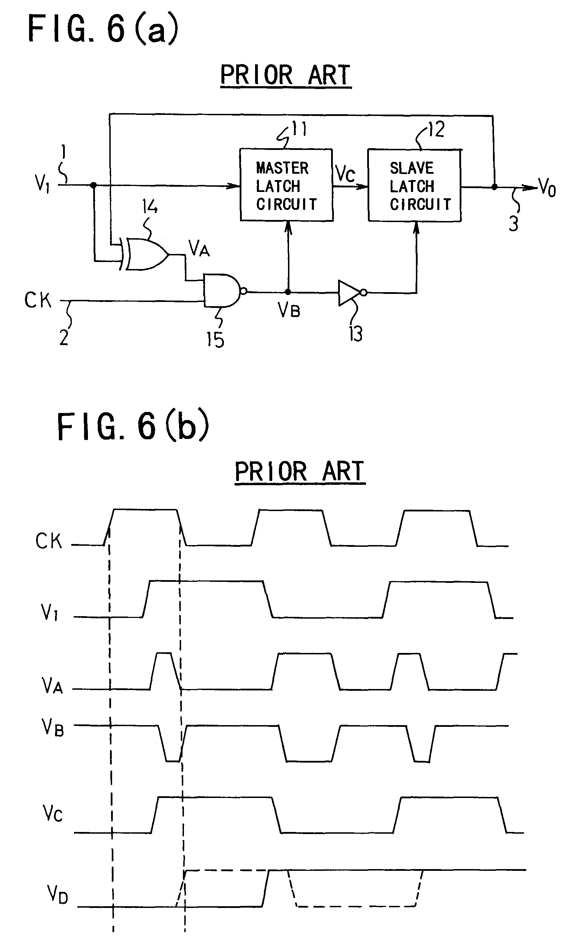

One of countermeasures for overcoming this drawback is disclosed in Japanese Patent Laid-Open Application No. Heisei 1-286609. FIG. 6(a) is a circuit diagram of the circuit shown in the figure 1 of the document just mentioned. Referring to FIG. 6(a), the circuit shown includes a master latch circuit 11 for sampling and latching a data input signal VI when a latch signal VB exhibits the "H" level, a slave latch circuit 12 for sampling and latching an output signal VC of the master latch circuit 11 when the latch signal VB exhibits the "L" level, an invertor 13 for inverting the latch signal VB and supplying the inverted latch signal to the slave latch circuit 12, an EX-OR (exclusive OR) circuit 14 for exclusively ORing an output signal VO of the slave latch circuit 12 and the data input signal VI, and a NAND circuit 15 for logically NANDing an output signal VA of the EX-OR circuit 14 and a clock input signal CK and outputting a latch signal VB.

Since the input signal VI and the output signal VO have an equal level unless the data input signal VI exhibits a change, the output signal VA is fixed to the "L" level and invalidates the clock signal CK to fix the latch signal VB to the "H" level. If the input signal VI changes, then the output signal VA changes to the "H" level, and the NAND circuit 15 validates the clock signal CK so that the master latch circuit 11 and the slave latch circuit 12 individually perform latching operations similarly as in an ordinary flip-flop. Consequently, the output of the entire circuit changes. In this instance, since the input signal VI and the output signal VO exhibit an equal level, unless the input signal VI exhibits a change again, the clock signal CK is invalidated by the EX-OR circuit 14.

A timing chart when the circuit described above operates is shown in FIG. 6(b). Referring to FIG. 6(b), when, in the operation within a period defined by two vertical broken lines in FIG. 6(b), the input signal VI changes from the "L" level to the "H" level while the clock signal CK is at the "H" level, since the level of the output signal VO and the level of the input signal VI are different from each other, the signal VA is changed to the "H" level by the EX-OR circuit 14. In this instance, since the clock input signal CK is at the "H" level, the latch signal VB is changed from the "H" level to the "L" level by the NAND circuit 15, and the master latch circuit 11 latches the signal level at the point of time when the data input signal VI changes to the "H" level since the latch signal VB has been at the "H" level till then, and outputs the latched signal level to the output VC of the master latch circuit 11. Here, since the latch signal VB changes to the "L" level, the "H" level of the output signal VC of the master latch circuit 11 is latched by the slave latch circuit 12, and the thus changing data are outputted as the output signal VO.

In this manner, as seen from the signal waveform VO of FIG. 6(b), depending upon the inputting timings of the input signal VI and the clock signal CK, the flip-flop circuit performs in such an operation as indicated by a broken line different from a normal operation indicated by a solid line, and data are outputted from the flip-flop circuit but not in synchronism with the clock signal CK. Consequently, the flip-flop circuit is disadvantageous in that it malfunctions in this regard.

Further, since the flip-flop circuit requires, in addition to such master latch circuit 11 and slave latch circuit 12 as are required by an ordinary flip-flop circuit, the EX-OR circuit 14 and the NAND circuit 15 for producing the latch signal VB, the flip-flop circuit is advantageous also in that a comparatively large number of elements are required to construct the entire flip-flop.

Furthermore, since the clock input signal CK is inputted to the master latch circuit 11 and the slave latch circuit 12 after it passes the NAND circuit 15 and the invertor 13, time is required after a change of the clock input signal CK till a change of the output signal VO, and this increases the propagation delay time as a flip-flop circuit.

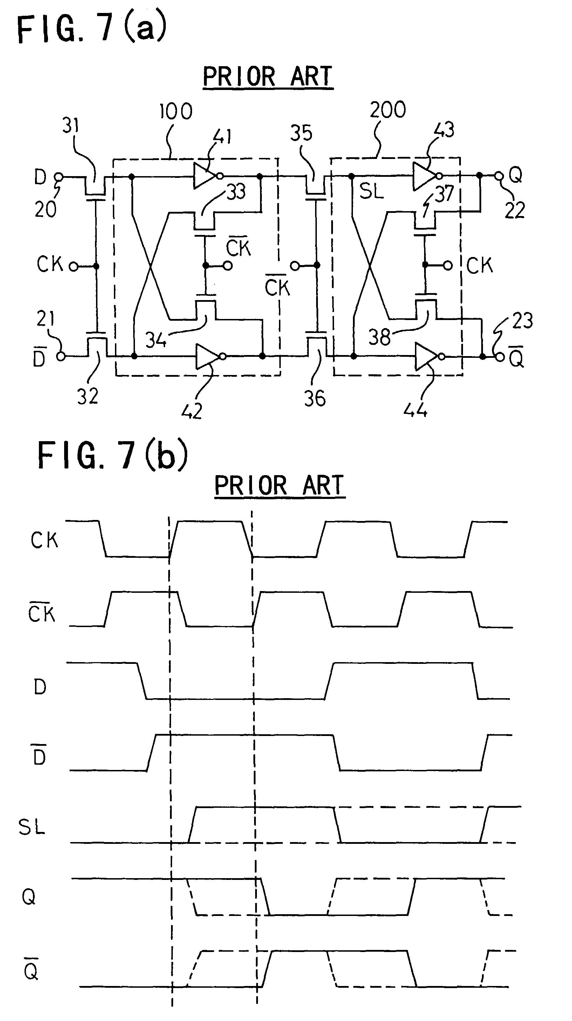

Another flip-flop circuit which contemplates reduction in power consumption is disclosed in Japanese Patent Laid-Open Application No. Heisei 2-34018. FIG. 7(a) is a circuit diagram shown in the figure 1 of the document just mentioned. Referring to FIG. 7(a), the flip-flop circuit shown includes a pair of transfer gates 31 and 32 which are switched between on and off in response to a clock input signal CK from the outside, a pair of invertors 41 and 42 connected in series in order in a forward direction to the transfer gates 31 and 32, respectively, another pair of transfer gates 33 and 34 connected in cross connection between input and output points of the invertors 41 and 42 and individually switchable between on and off in response to an opposite phase clock input signal $\overline{CK}$ having a phase opposite to that of the clock input signal CK, a further pair of transfer gates 35 and 36 connected to the output points of the invertors 41 and 42, respectively, and individually switchable between on and off in response to the opposite phase clock input signal $\overline{CK}$, another pair of invertors 43 and 44 connected in series in order in a forward direction between the transfer gates 35 and 36 and an output signal Q and an inverted output signal $\overline{Q}$, respectively, and a still further pair of transfer gates 37 and 38 connected in cross connection between input and output points of the invertors 43 and 44 and individually switchable between on and off in response to the clock input signal CK.

In this flip-flop circuit, the transfer gates 31 and 32 are turned on in response to a rising edge of the clock input signal CK from the "L" to the "H" level to fetch a data input signal D and an opposite phase data input signal $\overline{D}$ into a master latch circuit 100.

Then, when the clock input signal CK falls from the "H" to the "L" level, the transfer gates 33 and 36 are turned on, and the master latch circuit 100 holds the data input and simultaneously transfers the data to a slave latch circuit 200. Those data are outputted as the output signal Q and the opposite phase output signal $\overline{Q}$ of the slave latch circuit 200.

FIG. 7(b) shows a timing chart when the flip-flop circuit described above operates. Referring to FIG. 7(b), when, in the operation at a time indicated by a left side one of two vertical broken lines, the clock input signal CK changes from the "L" level to the "H" level, the inverted clock input signal $\overline{CK}$ changes from the "H" level to the "L" level after a fixed delay time. As a result, the transfer gates 31 to 38 are rendered conducting, and the data input signal D and the output signal Q are connected to each other by the transfer gates 31, 34, 36 and 37. Meanwhile, the opposite phase data input signal $\overline{D}$ and the opposite phase output signal $\overline{Q}$ are connected to each other by the transfer gates 32, 33, 35 and 38. Consequently, inputs SL to the slave circuit become unstable, and it is indefinite data of which one of the levels should be latched. In this manner, the flip-flop circuit of FIG. 7(a) sometimes malfunctions such that, when the clock input signal CK changes from the "L" level to the "H" level while the data input signal D and the output signal Q have different levels from each other, as seen from the signal waveform of the output Q of the slave latch circuit, the flip-flop circuit performs such an operation as indicated by a broken line different from a normal operation indicated by a solid line.

Further, since the circuit construction described above requires a clock input signal CK and an inverted clock input signal $\overline{CK}$, naturally an invertor for generation of the inverted clock signal is required. Since this invertor operates irrespective of a change in data, the flip-flop circuit is disadvantageous also in that the power consumption reduction effect is low and the power consumption increases in proportion to the operation frequency.

Further, time is required after a change of the clock input signal CK till a change of the output signal Q, and this increases the propagation delay time as a flip-flop.

In summary, the conventional flip-flop circuits described above are disadvantageous in the following points. First, with the flip-flop circuits shown in FIGS. 5(a) and 7(a), since an invertor for generating an inverted clock signal operates continuously even if the input data D does not change and the output data does not change, the power consumption increases in proportion to the operation frequency. This is because, since two input signals of the clock input signal CK and the inverted clock input signal $\overline{CK}$ are required from the circuit construction, two invertors for generating the inverted clock signal such as the inverters 96 and 97 in the flip-flop circuit of FIG. 5(a) naturally operate continuously irrespective of presence or absence of a change of the input data D.

Second, with the flip-flop circuit shown in FIG. 6(a), an input timing of the clock input signal CK and an input timing of the data input signal VI have a restriction in timing therebetween for stabilization of the circuit. This is because the circuit shown in FIG. 6(a) malfunctions if the level of the data input signal D changes when the clock input signal CK is at the "H" level. Further, the circuit shown in FIG. 7(a) malfunctions at a rising edge of the clock input signal CK when the input data and the output signal Q are different from each other if a delay difference appears between the clock input signal CK and the opposite phase clock input signal $\overline{CK}$.

Third, the flip-flop circuit shown in FIG. 6(a) is composed of a comparatively large number of elements and requires a comparatively large occupation area in a chip. This is because the circuit shown in FIG. 6(a) requires, in addition of the master latch circuit 11 and the slave latch circuit 12, the EX-OR circuit 14, the NAND circuit 15 and the invertor 13 in order to produce the latch signal VB.

Fourth, the circuits shown in FIGS. 5(a) and 6(a) are not suitable for high speed operation because time is required after a change of the clock input signal CK to a change of the data output signal Q or VO. This is because, since the clock input signal CK is inputted to the transfer gates via the invertors, time is required after a change in level of the clock input signal CK till a change in level of the output signal Q or VO.

It is an object of the present invention to provide a master-slave type flip-flop circuit which is composed of a reduced number of circuit components to reduce power consumption when input data does not exhibit a change to achieve reduction in power consumption and high speed operation.

In order to attain the object described above, according to the present invention, there is provided a master-slave type flip-flop circuit, comprising a master latch circuit for fetching or latching an external data input signal in synchronism with an external clock signal, the master latch circuit including first latch means for complementarily latching data on a first signal line and data on a second signal line, a slave latch circuit connected to the master latch circuit for fetching or latching data signals outputted from the master latch circuit in synchronism with the clock signal, the slave latch circuit including second latch means for complementarily latching data on a third signal line and data on a fourth signal line, the master-slave type flip-flop circuit operating with power supplied from first and second power supply voltage supplying means having different potentials, first current paths provided between the first and second signal lines and the first power supply voltage supplying means and second current paths provided between the third and fourth signal lines and the second power supply voltage supplying means such that the complementary data to be latched by the first latch means are defined by a voltage supply from the first power supply voltage supplying means to the first or second signal line whereas the complementary data to be latched by the second latch means are defined by a voltage supply from the second power supply voltage supplying means to the third or fourth signal line, and a first transfer gate for connecting or disconnecting the first current paths and a second transfer gate for connecting or disconnecting the second current paths, the first and second transfer gates being controlled between conducting and non-conducting states in response to the external clock signal, the external data input signal and the data signals from the first and second signal lines.

In the master-slave type flip-flop circuit, the external clock input signal is inputted directly to the transfer gates without passing a logic gate circuit. Consequently, when the data input signal inputted to the flip-flop circuit does not exhibit a change, no component consumes power irrespective of any change of the clock signal input. Accordingly, the power consumption is reduced as much, and the flip-flop circuit is low in power consumption. Further, since a result when the clock input signal is inputted directly to the transfer gates and the transfer gates are rendered conducting or non-conductive in response to the clock input signal is outputted, for example, through an invertor stage, the delay time after a change of the clock input signal till a change of the output signal at the output terminal is reduced, and consequently, the master-slave type flip-flop circuit is suitable for high speed operation.

Further, since the clock input signal and the data input signal are inputted directly and independently of each other to the transfer gates, such transfer gates as are formed from MOS transistors connected in a complicated connection or a logic gate circuit for generation of a latch signal is not required. Consequently, the master-slave type flip-flop circuit can achieve reduction in number of components, and this can reduce an occupation area of the master-slave type flip-flop circuit on a chip of an integrated circuit. Accordingly, high density integration can be achieved by the master-slave type flip-flop circuit. Further, since the transfer gate to which the data input signal is inputted and the transfer gate to which the clock input signal is inputted operate independently of each other, the clock input signal and the data input signal have no restriction in input timings for stabilization operation.

The above and other objects, features and advantages of the present invention will become apparent from the following description and the appended claims, taken in conjunction with the accompanying drawings in which like parts or elements are denoted by like reference characters.

FIG. 1(a) is a circuit diagram of a flip-flop circuit showing a first preferred embodiment of the present invention;
FIG. 1(b) is a time chart illustrating operation of the flip-flop circuit of FIG. 1(a);
FIG. 2(a) is a circuit diagram of another flip-flop circuit showing a second preferred embodiment of the present invention;
FIG. 2(b) is a time chart illustrating operation of the flip-flop circuit of FIG. 2(a);
FIG. 3 is a circuit diagram of a further flip-flop circuit showing a third preferred embodiment of the present invention;
FIG. 4 is a block diagram of a serial to parallel conversion circuit to which a flip-flop circuit according to the present invention is applied;
FIG. 5(a) is a circuit diagram showing an exemplary one of conventional flip-flop circuits;
FIG. 5(b) is a time chart illustrating operation of the flip-flop circuit of FIG. 5(a);
FIG. 6(a) is a circuit diagram showing another exemplary one of conventional flip-flop circuits;
FIG. 6(b) is a time chart illustrating operation of the flip-flop circuit of FIG. 6(a);
FIG. 7(a) is a circuit diagram showing a further exemplary one of conventional flip-flop circuits; and
FIG. 7(b) is a time chart illustrating operation of the flip-flop circuit of FIG. 7(a).

Referring first to FIG. 1(a), there is shown in circuit diagram a master-slave type flip-flop circuit according to a first preferred embodiment of the present invention.

The master-slave type flip-flop circuit has a clock input terminal 2 for receiving a clock input signal CK, a data input terminal 1 for receiving a data input signal D, and an output terminal 3 for outputting a output signal Q. A terminal of a first PMOS transfer gate 54 is connected to a power supply line 5, and also a terminal of a second PMOS transfer gate 55 is connected to the power supply line 5. The gate electrodes of the first and second PMOS transfer gates 54 and 55 are connected commonly to the clock input terminal 2, and the other terminal of the first PMOS transfer gate 54 is connected to a terminal of a third NMOS transfer gate 56 while the other terminal of the second PMOS transfer gate 55 is connected to a terminal of a fourth NMOS transfer gate 57. The gate electrode of the third NMOS transfer gate 56 is connected to the data input terminal 1, and also an input point of a first invertor 67 is connected to the data input terminal 1. The gate electrode of the fourth NMOS transfer gate 57 is connected to an output point of the first invertor 67, and the other terminal of the third NMOS transfer gate 56 is connected to an input point of a second invertor 58. The other terminal of the fourth NMOS transfer gate 57 is connected to an output point of the second invertor 58, and the output point of the second invertor 58 is connected to an input point of a third invertor 59. An output point of the third invertor 59 is connected to the input point of the second invertor 58. The second and third invertors 58 and 59 form a master latch section 50.

A terminal of a fifth NMOS transfer gate 61 is connected to a ground line 6, and also a terminal of a sixth NMOS transfer gate 62 is connected to the ground line 6. The gate electrodes of the fifth and sixth NMOS transfer gates 61 and 62 are connected commonly to the clock input terminal 2, and the other terminal of the fifth NMOS transfer gate 61 is connected to a terminal of a seventh NMOS transfer gate 63 while the other terminal of the sixth NMOS transfer gate 62 is connected to a terminal of an eighth NMOS transfer gate 64. The gate electrode of the seventh NMOS transfer gate 63 is connected to an output point of the third invertor 59 which forms the master latch section 50, and the gate electrode of the eighth NMOS transfer gate 64 is connected to an output point of the second invertor 58 which constructs the master latch circuit. The other terminal of the seventh NMOS transfer gate 63 is connected to an input point of a fourth invertor 65 and the other terminal of the eighth NMOS transfer gate 64 is connected to an output point of the fourth invertor 65, and the output point of the fourth invertor 65 is connected to an input point of a fifth invertor 66 and an output point of the fifth invertor 66 is connected to an input point of the fourth invertor 65. Thus, the fourth and fifth invertors 65 and 66 form a slave latch section 60. Further, an input point of a sixth invertor 68 is connected to the output point of the fourth invertor 66, and an output point of the sixth invertor 68 is connected to the output terminal 3.

The first and second PMOS transfer gates 54 and 55 are conducting when the clock input signal CK is at the "L" level whereas the fifth and sixth NMOS transfer gates 61 and 62 are conducting when the clock input signal CK is at the "H" level. On the other hand, the third NMOS transfer gate 56 is conducting when the data input signal D is at the "H" level where as the fourth NMOS transfer gate 57 is conducting when the data input signal D is at the "L" level. Further, the seventh and eighth NMOS transfer gates 63 and 64 are switched between conducting and non-conducting states in response to the output of the master latch circuit 50.

FIG. 1(b) is a timing chart when the circuit shown in FIG. 1(a) operates. Referring to FIG. 1(b), when the clock input signal CK changes from the "H" level to the "L" level, the first and second PMOS transfer gates 54 and 55 are rendered conducting. In this instance, since the data input signal D is at the "H" level, the third NMOS transfer gate 56 is rendered conducting, but the fourth NMOS transfer gate 57 is rendered non-conducting because an inverted signal to the data input signal D is inputted thereto from the first invertor 67.

The output Q1 of the master latch section 50 exhibits the "H" level equal to the potential of the power supply line 5 since the first PMOS transfer gate 54 and the third NMOS transfer gate 56 are in a conducting state, and the master latch section 50 holds the data of the "H" level.

When the clock input signal CK changes from the "L" level to the "H" level, the first and second PMOS transfer gates 54 and 55 are rendered non-conducting and simultaneously the fifth and sixth NMOS transfer gates 61 and 62 are rendered conducting. In this instance, since the output Q1 of the master latch section 50 and an inverted signal to the output Q1 are inputted to the seventh and eighth NMOS transfer gates 63 and 64, respectively, and the output signal Q1 of the master latch section 50 is "H" level data, the seventh NMOS transfer gate 63 is rendered conducting while the eighth NMOS transfer gate 64 is rendered non-conducting.

The output signal Q2 of the slave latch section 60 exhibits the "L" level equal to the potential of the ground line 6 since the fifth and seventh NMOS transfer gates 61 and 63 are conducting, and the slave latch section 60 holds the data of the "L" level. Since the signal Q2 of the "L" level is inverted by the sixth invertor 68 of the slave latch circuit, the output terminal Q outputs a signal of the "H" level.

Due to the circuit construction and the operation described above, the master-slave type flip-flop circuit is advantageous in the following points.

(A) Since the first and second PMOS transfer gates 54 and 55 and the fifth and sixth NMOS transfer gates 61 and 62 are rendered conducting or non-conducting directly in response to the clock input signal CK, an inverted clock input signal and an invertor for production of an inverted clock signal are not required. Accordingly, the master-slave type flip-flop circuit is very low in power consumption and high in operation speed.

(B) Since the first and second PMOS transfer gates 54 and 55 to which the clock input signal CK is inputted and the third and fourth NMOS transfer gates 56 and 57 to which the data input signal D is inputted operate independently of each other, the clock input signal CK and the data input signal D have no restriction in timing therebetween, and normally stable operation is anticipated with the master-slave type flip-flop circuit.

(C) The number of elements which form the flip-flop circuit is comparatively small, and the flip-flop circuit is reduced in occupation area in a chip and facilitates high density integration.

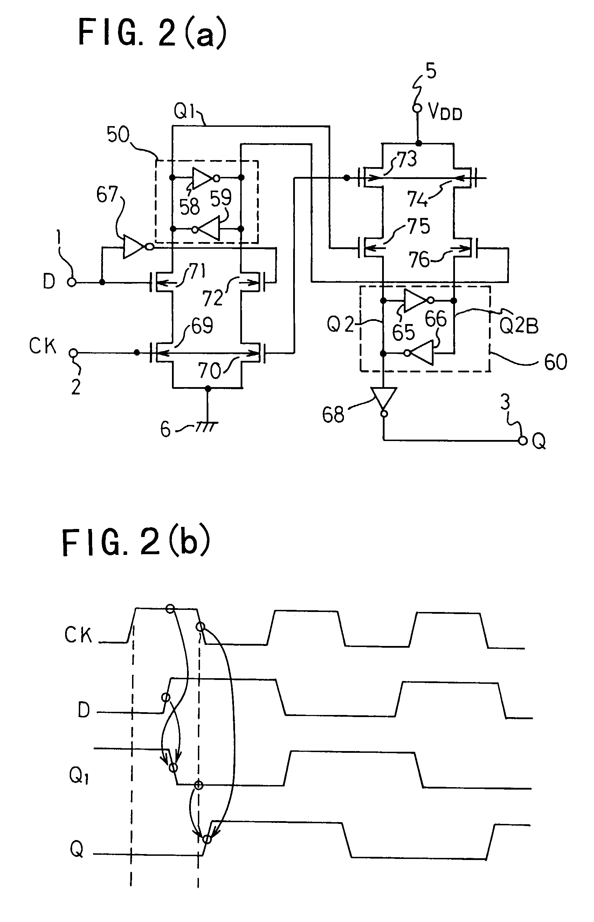

Referring now to FIG. 2(a), there is shown in circuit diagram a master-slave type flip-flop circuit according to a second preferred embodiment of the present invention. The master-slave type flip-flop circuit shown has a clock input terminal 2 for receiving a clock input signal CK, a data input terminal 1 for receiving a data input signal D, and an output terminal 3 for outputting an output signal Q. A terminal of a first NMOS transfer gate 69 is connected to a ground line 6, and also a terminal of a second NMOS transfer gate 70 is connected to the ground line 6. The gate electrodes of the first and second NMOS transfer gates 69 and 70 are connected commonly to the clock input terminal 2, and the other terminal of the first NMOS transfer gate 69 is connected to a terminal of a third NMOS transfer gate 71 and the other terminal of the second NMOS transfer gate 70 is connected to a terminal of a fourth NMOS transfer gate 72. The gate electrode of the third NMOS transfer gate 71 is connected to the data input terminal 1 and also an input point of a first invertor 67 is connected to the data input terminal 1, and the gate electrode of the fourth NMOS transfer gate 72 is connected to an output point of the first invertor 67. The other terminal of the third NMOS transfer gate 71 is connected to an input point of a second invertor 58, and the other terminal of the fourth NMOS transfer gate 72 is connected to an output point of the second invertor 58. The output point of the second invertor 58 is connected to an input point of a third invertor 59, and an output point of the third invertor 59 is connected to the input point of the second invertor 58. The second and third invertors 58 and 59 thus form a master latch section 50.

A terminal of a fifth PMOS transfer gate 73 is connected to a power supply line 5, and also a terminal of a sixth PMOS transfer gate 74 is connected to the power supply line 5. The gate electrodes of the fifth and sixth PMOS transfer gates 73 and 74 are connected commonly to the clock input terminal 2, and the other terminal of the fifth PMOS transfer gate 73 is connected to a terminal of a seventh NMOS transfer gate 75 and the other terminal of the sixth PMOS transfer gate 74 is connected to a terminal of an eighth NMOS transfer gate 76. The gate electrode of the seventh NMOS transfer gate 75 is connected to the output point of the third invertor 59 which forms the master latch section 50, and the gate electrode of the eighth NMOS transfer gate 76 is connected to the output point of the second invertor 58 which forms the master latch section 50. The other terminal of the seventh NMOS transfer gate 75 is connected to an input point of a fourth invertor 65, and the other terminal of the eighth NMOS transfer gate 76 is connected to an output point of the fourth invertor 65. The output point of the fourth invertor 65 and the input point of the fifth invertor 66 are connected each other, and the output point of the fifth invertor 66 is connected to the input point fourth invertor 65. Thus, the fourth and fifth invertors 65 and 66 form a slave latch section 60. An input point of a sixth invertor 68 is connected to the output point of the fifth invertor 66, and an output point of the sixth invertor 68 is connected to the output terminal 3.

The first and second NMOS transfer gates 69 and 70 are conducting when the clock input signal CK is at the "H" level, but the fifth and sixth PMOS transfer gates 73 and 74 are conducting when the clock input signal CK is at the "L" level. Further, the seventh and eighth NMOS transfer gates 75 and 76 are switched between conducting and non-conducting states in response to an output of the master latch section 50.

FIG. 2(b) is a timing chart when the circuit of FIG. 2(a) operates. Referring to FIG. 2(b), when the clock input signal CK changes from the "L" level to the "H" level, the first and second NMOS transfer gates 69 and 70 are rendered conducting. If the data input signal D rises from the "L" level to the "H" level in this condition, then the third NMOS transfer gate 71 is rendered conducting. On the other hand, the fourth NMOS transfer gate 72 is rendered non-conducting because an inverted signal to the data input signal D is inputted thereto from the first invertor 67. As a result, the output Q1 of the master latch section 50 exhibits the "L" level equal to the potential of the ground line 6 since the first and third NMOS transfer gates 69 and 71 are conducting, and the master latch section 50 holds the data of the "L" level.

If the clock input signal CK falls from the "H" level to the "L" level, then the first and second NMOS transfer gates 69 and 70 are rendered non-conducting while the fifth and sixth PMOS transfer gates 73 and 74 are rendered conducting. Since the output Q1 of the master latch section 50 and an inverted signal to the output Q1 are inputted to the seventh and eighth NMOS transfer gates 75 and 76, respectively, and the output Q1 of the master latch section 50 is data of the "L" level, the seventh NMOS transfer gate 75 is rendered non-conducting while the eighth NMOS transfer gate 76 is rendered conducting. As a result, the signal Q2B of the slave latch section 60 exhibits the "H" level equal to the potential of the power supply since the sixth PMOS transfer gate 74 and the eighth NMOS transfer gate 76 are conducting. Accordingly, the slave latch section 60 holds the data of the "L" level inverted from the signal Q2B. Since the data Q2 of the "L" level is inverted by the sixth invertor 68 connected to the output signal Q2 of the slave latch section 60, the output terminal 3 outputs a signal Q of the "H" level.

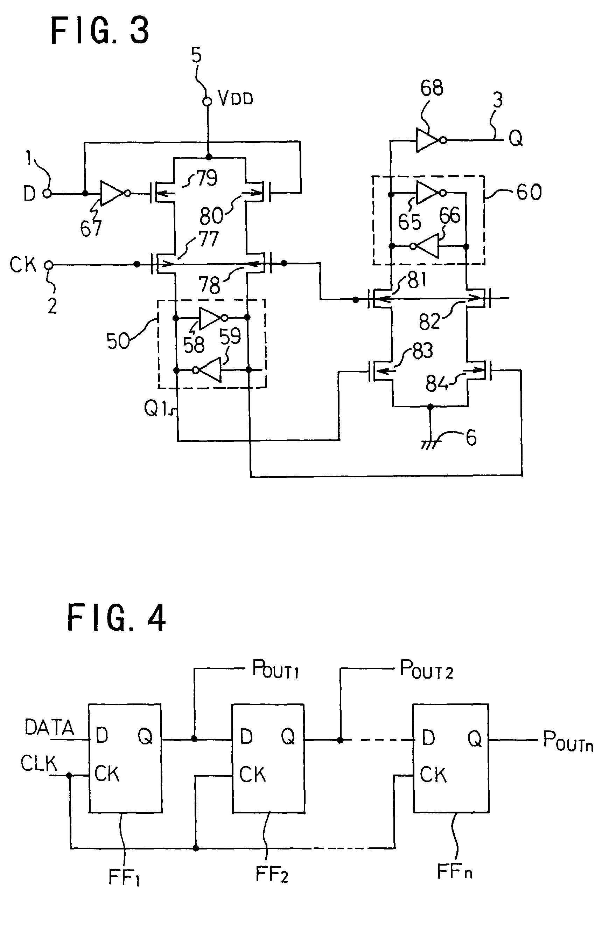

Referring now to FIG. 3(a), there is shown in circuit diagram a master-slave type flip-flop circuit according to a third preferred embodiment of the present invention. The master-slave type flip-flop circuit shown has a clock input terminal 2 for receiving a clock input signal CK, a data input terminal 1 for receiving a data input signal D, and an output terminal 3 for outputting a data output signal Q. A terminal of a first NMOS transfer gate 79 is connected to a power supply line 5, and also a terminal of a second NMOS transfer gate 80 is connected to the power supply line 5. The other terminal of the first NMOS transfer gate 79 is connected to a terminal of a third PMOS transfer gate 77, and the other terminal of the second NMOS transfer gate 80 is connected to a fourth PMOS transfer gate 78. The gate electrode of the second NMOS transfer gate 80 is connected to the data input terminal 1, and also an input point of a first invertor 67 is connected to the data input terminal 1. The gate electrode of the first NMOS transfer gate 79 is connected to an output point of the first invertor 67, and the gate electrodes of the third and fourth PMOS transfer gates 77 and 78 are connected commonly to the clock input terminal 2. The other terminal of the third PMOS transfer gate 77 is connected to an input point of a second invertor 58, and the other terminal of the fourth PMOS transfer gate 78 is connected to an output point of the second invertor 58. The output point of the second invertor 58 is connected to an input point of a third invertor 59, and an output point of the third invertor 59 is connected to the input point of the second invertor 58. The second and third invertors 58 and 59 thus form a master latch section 50.

A terminal of a fifth NMOS transfer gate 83 is connected to a ground line 6, and also a terminal of a sixth NMOS transfer gate 84 is connected to the ground line 6. The gate electrode of the fifth NMOS transfer gate 83 is connected to the output point of the third invertor 59 which forms the master latch section 50, and the gate electrode of the sixth NMOS transfer gate 84 is connected to the output point of the second invertor 58 which forms the master latch section 50. The other terminal of the fifth NMOS transfer gate 83 is connected to a terminal of a seventh NMOS transfer gate 81, and the other terminal of the sixth NMOS transfer gate 84 is connected to a terminal of an eighth NMOS transfer gate 82. The gate electrodes of the seventh and eighth NMOS transfer gates 81 and 82 are connected commonly to the clock input terminal 2. The other terminal of the seventh NMOS transfer gate 81 is connected to an input point of a fourth invertor 65, and the other terminal of the eighth NMOS transfer gate 82 is connected to an output point of the fourth invertor 65. The output point of the fourth invertor 65 is connected to an input point of a fifth invertor 66, and an output point of the fifth invertor 66 is connected to the input point of the fourth invertor 65. The fourth and fifth invertors 65 and 66 thus form a slave latch section 60. An input point of a sixth invertor 68 is connected to the output point of the fifth invertor 66, and an output point of the sixth invertor 68 is connected to the output terminal 3.

The master-slave type flip-flop circuit of FIG. 3 operates basically similar to that of the master-slave type flip-flop circuit of FIG. 1(a). However, since the third and fourth PMOS transfer gates 77 and 78 and the seventh and eighth NMOS transfer gates 81 and 82 which are switched between conducting and non-conducting states in response to a change of the clock input signal CK are connected to positions near to the master latch section 50 or the output terminal 3, the times after a change of the clock input signal CK till a change of the held data by the master latch section 50 and a change of the data output signal Q are short. Consequently, the present master-slave type flip-flop circuit exhibits an improved operation speed.

FIG. 4 shows in circuit diagram an exemplary application of a master-slave type flip-flop circuit according to the present invention. The master-slave type flip-flop circuit of the present invention does not include an element which operates in response to a change of the clock input signal CK and consumes power when the data input signal D does not change as described hereinabove. Consequently, where such master-slave type flip-flop circuits are connected in series as seen in FIG. 4 to construct a series to parallel conversion circuit, the power consumption reduction effect appears significantly, and where a large number of flip-flop circuits are connected in series, the effect is very significant.

Having now fully described the invention, it will be apparent to one of ordinary skill in the art that many changes and modifications can be made thereto without departing from the spirit and scope of the invention as set forth herein.

**Claims**

1. A master-slave type flip-flop circuit which includes a master latch circuit for fetching or latching an external data input signal (D) in synchronism with an external clock signal (CK), said master latch circuit including first latch means (50) for complementarily latching data on a first signal line and data on a second signal line, and a slave latch circuit connected to said master latch circuit for fetching or latching data signals outputted from said master latch circuit in synchronism with the clock signal (CK), said slave latch circuit including second latch means (60) for complementarily latching data on a third signal line and data on a fourth signal line, and operates with power supplied from first and second power supply voltage supplying means (5, 6) having different potentials, characterized in that it comprises:

first current paths provided between said first and second signal lines and said first power supply voltage supplying means (5) and second current paths provided between said third and fourth signal lines and said second power supply voltage supplying means (6) such that the complementary data to be latched by said first latch means (50) are defined by a voltage supply from said first power supply voltage supplying means (5) to said first or second signal line whereas the complementary data to be latched by said second latch means (60) are defined by a voltage supply from said second power supply voltage supplying means (6) to said third or fourth signal line; and

a first transfer gate (54 to 57; 69 to 72; 77 to 80) for connecting or disconnecting said first current paths and a second transfer gate (61 to 64; 73 to 76; 81 to 84) for connecting or disconnecting said second current paths, said first and second transfer gates (54 to 57, 61 to 64; 69 to 72, 73 to 76; 77 to 80, 81 to 84) being controlled between conducting and non-conducting states in response to the external clock signal (CK), the external data input signal (D) and the data signals from said first and second signal lines.

2. A master-slave type flip-flop circuit which includes a master latch circuit including first latch means (50) provided between a first signal line and a second signal line for complementarily latching data on said first and second signal lines, and a slave latch circuit including second latch means (60) provided between a third signal line and a fourth signal line for complementarily latching data signals on said third and fourth signal lines, said master latch circuit and said slave latch circuit being connected in cascade connection, and operates with power supplied from first and second power supply voltage supplying means (5, 6) having different potentials, characterized in that

said master latch circuit further includes a transfer gate (54, 55; 69, 70; 77, 78) which is rendered conducting or non-conducting in response to an external clock signal (CK) and another transfer gate (56, 57; 71, 72; 79, 80) which is rendered conducting or non-conducting in response to an external data input signal (D) or an inverted signal to the external data input signal (D) such that said first and second signal lines are alternately connected to said first power supply voltage supplying means (5) in response to the data input signal (D) in synchronism with the clock signal (CK) so that the complementary data of said first and second signal lines are compelled to states defined by the data input signal (D) by the supply voltage from said first power supply voltage supplying means (5), and

said slave latch circuit further includes a transfer gate (61, 62; 73, 74; 81, 82) which is rendered conducting or non-conducting in response to the clock signal (CK) and another transfer gate (63, 64; 75, 76; 83, 84) which is rendered conducting or non-conducting in response to the complementary data from the first and second signal lines of said master latch circuit such that said third and fourth signal lines are alternately connected to said second power supply voltage supplying means (6) in response to the complementary from said first and second signal lines of said master latch circuit in synchronism with the clock signal (CK) so that the complementary data of said third and fourth signal lines are compelled to states defined by the complementary data of said first and second signal lines by the supply voltage from said second power supply voltage supplying means (6).

3. A master-slave type flip-flop circuit which includes a data input terminal (1), a clock input terminal (2), an output terminal (3) and first and second power supplying means (5, 6) for supplying different voltages, characterized in that it comprises:

a master latch circuit including first and second transfer gates (54, 55; 69, 70; 77, 78) which are rendered conducting or non-conducting in response to a clock signal (CK), third and fourth transfer gates (56, 57; 71, 72; 79, 80) which are rendered conducting or non-conducting in response to a data input signal (D), said first and second transfer gates (54, 55; 69, 70; 77, 78) and said third and fourth transfer gates (56, 57; 71, 72; 79, 80) being connected in series to form first and second signal lines, respectively, and latch means (50) connected at a terminal thereof to said first signal line and at another terminal thereof to said second signal line such that said first and second signal lines are complementary to each other; and

a slave latch circuit including fifth and sixth transfer gages (61, 62; 73, 74; 81, 82) which are rendered conducting or non-conducting in response to the clock signal (CK), seventh and eighth transfer gates (63, 64; 75, 76; 83, 84) which are rendered conducting or non-conducting in response to an output signal of said master latch circuit, said fifth and sixth transfer gates (61, 62; 73, 74; 81, 82) and said seventh and eighth transfer gates (63, 64; 75, 76; 83, 84) being connected in series to form third and fourth signal lines, respectively, and latch means (60) connected at a terminal thereof to said third signal line and at another terminal thereof to said fourth signal line such that said third and fourth signal lines are complementary to each other.

**4.** A master-slave type flip-flop circuit as set forth in claim 3, characterized in that said first to eighth transfer gates (54 to 57, 63 to 66; 69 to 72, 73 to 76; 77 to 80, 81 to 84) are each formed from a conducting type MOS field effect transistor.

**5.** A master-slave type flip-flop circuit, characterized in that it comprises:

a master latch circuit including first latch means (50) including a pair of invertors (58, 59) each connected at an input point to an output point of the other invertor for complementarily latching data of first and second signal lines connected to two junction points of said invertors (58, 59), a first p-channel MOS field effect transistor (54) and a second n-channel MOS field effect transistor (56) connected in series in order between a high potential power supply voltage supplying line (5) and said first signal line, and a third p-channel MOS field effect transistor (55) and a fourth n-channel MOS field effect transistor (57) connected in series in order between said high potential power supply voltage supplying line (5) and said second signal line, an external clock signal (CK) being inputted to the gate electrodes of said first and third MOS field effect transistors (54, 55), an external data signal (D) being inputted to the gate electrode of said second MOS field effect transistor (56), an inverted signal to the data signal (D) being inputted to the gate electrode of said fourth MOS field effect transistor (57); and a slave latch circuit including second latch means (60) including a pair of invertors (65, 66) each connected at an input point to an output point of the other invertor for complementarily latching data of third and fourth signal lines connected to two junction points of said invertors (65, 66), a fifth n-channel MOS field effect transistor (61) and a sixth n-channel MOS field effect transistor (63) connected in series in order between a low potential power supply voltage supplying line (6) and said third signal line, and a seventh n-channel MOS field effect transistor (62) and an eighth n-channel MOS field effect transistor (64) connected in series in order between said low potential power supply voltage supplying line (6) and said fourth signal line, the clock signal (CK) being inputted to the gate electrodes of said fifth and seventh MOS field effect transistors (61, 62), a signal from said first signal line in said master latch circuit being inputted to the gate electrode of said sixth MOS field effect transistor (63), a signal from said second signal line in said master latch circuit being inputted to the gate electrode of said eighth MOS field effect transistor (64).

**6.** A master-slave type flip-flop circuit, characterized in that it comprises:

a master latch circuit including first latch means (50) including a pair of invertors (58, 59) each connected at an input point to an output point of the other invertor for complementarily latching data of first and second signal lines connected to two junction points of said invertors (58, 59), a first n-channel MOS field effect transistor (69) and a second n-channel MOS field effect transistor (71) connected in series in order between a low potential power supply voltage supplying line (6) and said first signal line, and a third n-channel MOS field effect transistor (70) and a fourth n-channel MOS field effect transistor (72) connected in series in order between said low potential power supply voltage supplying line (6) and said second signal line, an external clock signal (CK) being inputted to the gate electrodes of said first and third MOS field effect transistors (69, 70), an external data signal (D) being inputted to the gate electrode of said second MOS field effect transistor (71), an inverted signal to the data signal (D) being inputted to the gate electrode of said fourth MOS field effect transistor (72); and a slave latch circuit including second latch means (60) including a pair of invertors (65, 66) each connected at an input point to an output point of the other invertor for complementarily latching data of third and fourth signal lines connected to two junction points of said invertors (65, 66), a fifth p-channel MOS field effect transistor (73) and a sixth n-channel MOS field effect transistor (75) connected in series in order between a high potential power supply voltage supplying line (5) and said third signal line, and a seventh p-channel MOS field effect transistor (74) and an eighth n-channel MOS field effect transistor (76) connected in series in order between said high potential power supply voltage supplying line (5) and said fourth signal line, the clock signal (CK) being inputted to the gate electrodes of said fifth and seventh MOS field effect transistors (73, 74), a signal from said first signal line in said master latch circuit being inputted to the gate electrode of said sixth MOS field effect transistor (75), a signal from said second signal line in said master latch circuit being inputted to the gate electrode of said eighth MOS field effect transistor (76).

**7.** A master-slave type flip-flop circuit, characterized in that it comprises:

a master latch circuit including first latch means (50) including a pair of invertors (58, 59) each connected at an input point to an output point of the other invertor for complementarily latching data of first and second signal lines connected to two junction points of said invertors (58, 59), a first n-channel MOS field effect transistor (79) and a second p-channel MOS field effect transistor (77) connected in series in order between a high potential power supply voltage supplying line (5) and said first signal line, and a third n-channel MOS field effect transistor (80) and a fourth p-channel MOS field effect transistor (78) connected in series in order between said high potential power supply voltage supplying line (5) and said second signal line, an inverted signal to an external data signal (D) being inputted to the gate electrode of said first MOS field effect transistor (79), the data signal (D) being inputted to the gate electrode of said third MOS field effect transistor (80), an external clock signal (CK) being inputted to the gate electrodes of said second and fourth MOS field effect transistors (77, 78); and

a slave latch circuit including second latch means (60) including a pair of invertors (65, 66) each connected at an input point to an output point of the other invertor for complementarily latching data of third and fourth signal lines connected to two junction points of said invertors (65, 66), a fifth n-channel MOS field effect transistor (83) and a sixth n-channel MOS field effect transistor (81) connected in series in order between a low potential power supply voltage supplying line (6) and said third signal line, and a seventh n-channel MOS field effect transistor (84) and an eighth n-channel MOS field effect transistor (82) connected in series in order between said low potential power supply voltage supplying line (6) and said fourth signal line, a signal from said first signal line in said master latch circuit being inputted to the gate electrode of said fifth MOS field effect transistor (83), a signal from said second signal line in said master latch circuit being inputted to the gate electrode of said seventh MOS field effect transistor (84), the clock signal (CK) being inputted to the gate electrodes of said sixth and eighth MOS field effect transistors (81, 82).

# FIG. 1 (a)

# FIG. 1 (b)

# FIG. 2(a)

# FIG. 2(b)

EP 0 793 342 A2

# FIG. 3

# FIG. 4

13

# FIG. 5(a)

## PRIOR ART

# FIG. 5(b)

## PRIOR ART

EP 0 793 342 A2

# FIG. 6 (a)

## PRIOR ART

# FIG. 6 (b)

## PRIOR ART

15

# FIG. 7 (a)

<u>PRIOR ART</u>

# FIG. 7 (b)

<u>PRIOR ART</u>